Europäisches Patentamt

European Patent Office

Office européen des brevets

(19)

(11) Numéro de publication: **0 269 477 B1**

## FASCICULE DE BREVET EUROPEEN

(45) Date de publication de fascicule du brevet: **22.07.92** (51) Int. Cl.5: **H01L 29/78**

(21) Numéro de dépôt: **87402341.9**

(22) Date de dépôt: **20.10.87**

(54) **Procédé de fabrication d'un composant MOS.**

(30) Priorité: **24.10.86 FR 8614832**

(43) Date de publication de la demande:
**01.06.88 Bulletin 88/22**

(45) Mention de la délivrance du brevet:
**22.07.92 Bulletin 92/30**

(84) Etats contractants désignés:
**BE DE ES GB IT NL SE**

(56) Documents cités:
**EP-A- 0 097 866**
**FR-A- 2 475 293**

(73) Titulaire: **SGS-THOMSON MICROELECTRO-NICS S.A.**
**7, Avenue Galiiéni**
**F-94250 Gentilly(FR)**

(72) Inventeur: **Rouault, Gwenael**
**THOMSON-CSF SCPI**
**F-92045 PARIS LA DEFENSE CEDEX 67(FR)**
Inventeur: **Guerner, Hervé**
**THOMSON-CSF SCPI**
**F-92045 PARIS LA DEFENSE CEDEX 67(FR)**

(74) Mandataire: **de Beaumont, Michel**
**1bis, rue Champollion**
**F-38000 Grenoble(FR)**

Rank Xerox (UK) Business Services

## Description

L'invention concerne un procédé de fabrication par auto-alignement des zones dopées d'un composant MOS. Elle trouve application dans la fabrication de produits MOS et BIP MOS, nommés aussi I G T, COMFET, GEMFET, à grille en silicum polycristallin désigné sous le vocable de polysilicium. Elle s'applique tout particulièrement à la fabrication de technologie VD MOS (verticaly metal oxyde semiconductor).

Un composant de type DMOS est constitué par des cellules ou des bandes où sont pris les contacts de source et par des zones de grille constituées d'oxyde et de polysilicium. Dans les cellules il faut introduire des impuretés :
- de type P qui détermineront les paramètres du canal,
- N + : qui détermineront les paramètres de sources,
- P + : qui interviendront pour l'obtention de bonnes caractéristiques de :
  - conctact ohmique avec la connexion en aluminium,
  - tenue en tension,
  - résistance Rb du transistor NPN latéral parasite.

Les impuretés N + et P sont limitées par le polysilicium. Ce sont les différents recuits qui déterminent les longueurs et le dopage du canal. Ces deux paramètres sont ainsi les mêmes pour toutes les cellules qui composent le MOS.

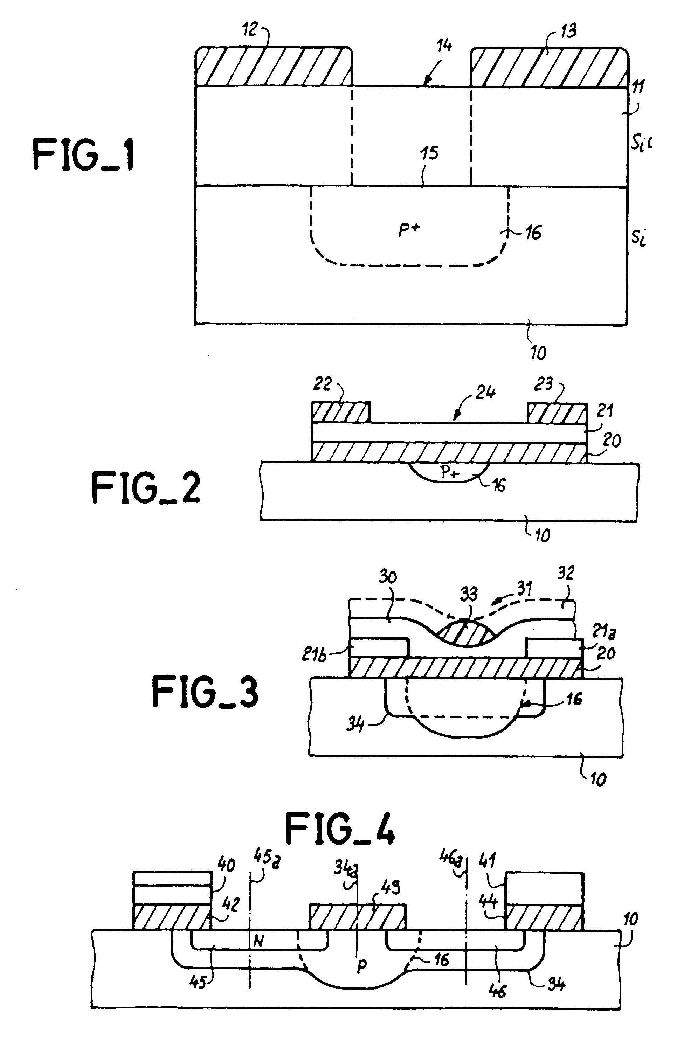

Dans l'art antérieur, les ouvertures correspondant au polysilicium et à la diffusion P + et N + sont faites séparément. L'inconvénient majeur de ce procédé est que la zone P + n'est pas systématiquement centrée par rapport à l'ouverture dans le polysilicium. Un exemple d'un tel procédé apparaît dans EP-A-0097866 où l'ouverture de formation de la région P$^+$ (26 en Fig. 4) n'est pas auto-centrée sur l'ouverture délimitant les régions N$^+$ (22 en Fig. 2). Le problème se présente aussi pour la zone où on ne diffuse pas d'impureté N + . L'invention apporte une solution aux inconvénients de l'art antérieur, notamment en vue de centrer les zones de dopage et de supprimer les défauts de centrage de celles-ci. Il comprend les étapes de la revendication 1.

A la figure 1, on a représenté une étape du procédé de fabrication classique de l'art antérieur. D'une plaquette de silicium 10, on réalise une oxydation superficielle 11, un dépôt de résine 12,13 ménageant une première fenêtre 14 pour réaliser un premier dopage. Un masque numéro 1 d'insolation permet de dégager la fenêtre 14. On dégage la fenêtre de l'oxyde de façon à atteindre la surface 15 du silicium 10. On réalise :
1 - lavage,

2 - implantation (l'oxyde fait écran)
3 - recuit.

Pour terminer l'opération, on enlève le reste de l'oxyde.

A la figure 2, on a représenté la suite du procédé classique. Il ne pose pas au départ de problèmes particuliers. On oxyde le silicium pour créer une première couche de SiO$_2$ 20 qui réalisera l'oxyde du transistor MOS. Puis on dépose une couche de polysilicium 21 et une couche de résine 22,23. On dispose alors un second masque pour insoler une seconde fenêtre, centrée sur la première 14, et plus large que celle-ci. Son centrage est particulièrement important pour la qualité future du produit. On dégage une fenêtre 24 par insolation puis on attaque la couche 21 de polysilicium par plasma.

A la figure 3, la fenêtre ainsi constituée est limitée par deux plaques 21a et 21b de polysilicium 21. On réalise une implantation de type P dans le silicium 10 à travers la couche d'oxyde 20. Les plaques de polysilicium 21a et 21b font écran à cette implantation. On peut alors élargir la zone dopée 16 par implantation de part et d'autre de la zone 16 selon un profil 34. On réalise ensuite une oxydation ou un dépôt d'oxyde. On dépose alors une nouvelle couche de résine 32 par dessus l'ensemble, et un nouveau masque est appliqué de manière à ménager seulement une zone 33 protégée par de la résine après insolation. Le centrage de ce troisième masque est encore une nouvelle source d'erreurs. Puis on attaque la couche 30 d'oxyde et on lave la résine.

A la figure 4, le composant est fini après une double implantation 45,46 de part et d'autre du plot d'oxyde 43, sauvegardé à l'insolation par la résine 33 de la figure 3, et un recuit du composant. Il suffit alors de préparer les connexions.

Un gros problème de précision se pose, si on veut garantir les performances du composant, pour positionner les masques afin que les axes médians 45a et 46a des zones dopées N et 34a de la zone dopée P soient convenablement disposés relativement aux trois plots 40,42 -43 - 41,44 de jonctions oxyde.

L'invention part du constat du problème de précision de ce procédé de diffusion verticale pour fabriquer un composant MOS.

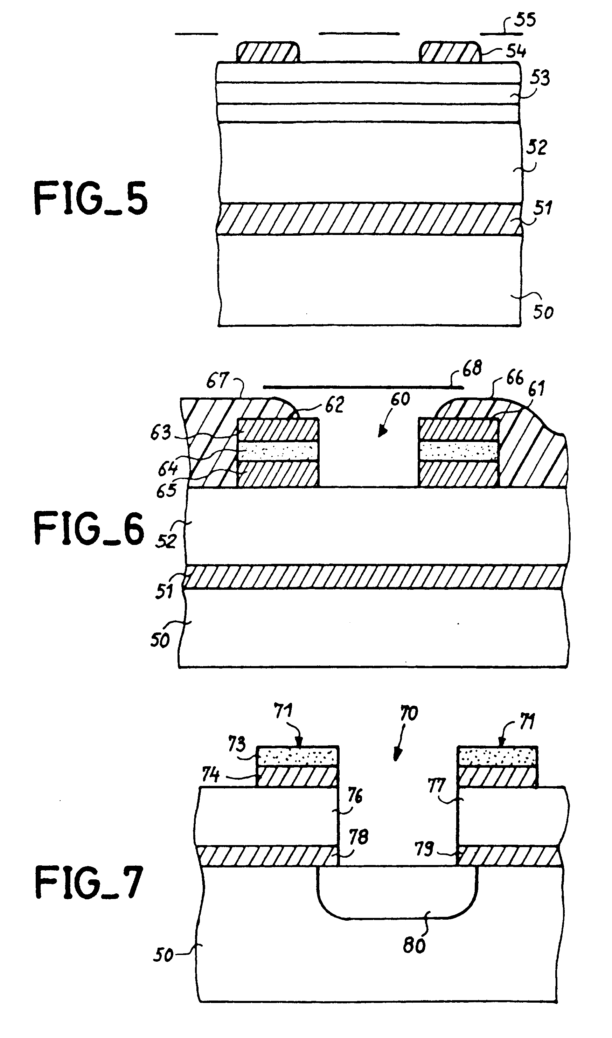

A la figure 5, on a représenté un premier état du processus de fabrication d'un circuit intégré selon l'invention. Un exemple de réalisation à trois couches est représenté. D'autres réalisations non décrites ont été réalisées à cinq ou sept couches.

La couche 50 est un substrat silicium. Une seconde couche 51, constituée par croissance thermique à l'oxydation de la couche 50 ou par un dépôt de type LPCVD, est on oxyde de silicium. Cette couche est destinée à constituer l'oxyde séparant le polysilicium du contact du substrat. Une troisième couche 52 de polysilicium est ensuite déposée puis dopée.

Ensuite, un tri couche 53 est prévue pour créer des plots de protection de la couche de polysilicium 52. Cette couche 53 sera progressivement consommée au cours du procédé de fabrication, mais, elle permet de transporter la précision du premier masquage sur tous les masquages ou gravures directes suivantes évitant ainsi les problèmes d'alignement inhérents à la gravure micronique et submicronique.

Une couche de résine 54 est appliquée, un masque 55 et une insolation retrait permet de créer des fenêtres de gravure de la couche de protection 53.

A la figure 6, on a représenté une seconde étape du procédé selon l'invention. Depuis la figure 5, on a créé une fenêtre 60 à travers l'épaisseur de la couche 53 de protection jusqu'au polysilicium de la couche 52. La couche de protection 53, dans l'appliccation de l'invention à la fabrication d'un IGFET, comporte trois sous couches 63 et 65 d'oxyde de silicium $SiO_2$ et 64 de nitrure de silicium $Si_3N_4$.

Or, les conditions de gravure de l'oxyde et du polysilicium sont suffisamment éloignées pour que l'oxyde soit un masque pour la gravure du polysilicium. De plus, l'oxyde joue le même rôle pour le nitrure de silicium. Une autre caractéristique importante est utilisée par l'invention : le nitrure $Si_3N_4$ s'oxyde environ dix fois moins vite que le silicium aux mêmes conditions d'oxydation. La conjonction de ces deux caractéristiques physico-chimiques permet la mise en oeuvre de l'invention à savoir la création de fenêtres auto-alignées successives dans un procédé de fabrication d'un circuit intégré multicouches, L'homme de métier sait adapter les propriétés précitées à d'autres triades que celle (-$(Si)_n$, $Si_3N_4$, $SiO_2$) décrite ci-après.

A la figure 6, on a ensuite déposé une couche de résine 66,67et appliqué un deuxième masque de photolithographie 68. Ce masque est placé au-dessus des fenêtres 60 obtenues entre deux plots de protection 61,62. On constate ainsi que les plots de protection permettent de ne pas centrer le deuxième masque avec une précision très élevée par rapport à la fenêtre 60 et donc au premier masque.

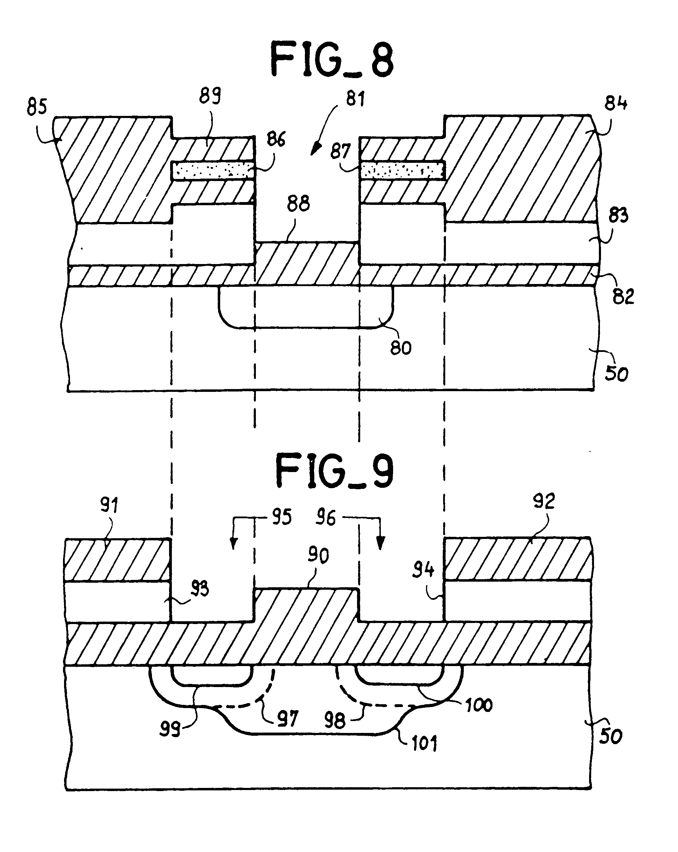

A la figure 7, on a réalisé une gravure par attaque chimique du polysilicium de la couche 52. La résine et le tri couche 53 ont a protégé le polysilicium en dehors de la fenêtre de gravure 60 de la figure 6. On enlève alors les zones de résine. Puis, on a réalisé une gravure chimique de l'oxyde de la couche 51 dans la fenêtre 70 et des couches 63 des plots de protection 61 et 62 de la figure 6. A la figure 7, les plots de protection 71 et 72 ne sont plus constitués que des couches de nitrure 73 et d'oxyde inférieur 74. De l'autre côté de chaque plot 71 ou 72, par rapport à la fenêtre 70, le polysilicium 76 et 77 protège la couche enterrée 78 ou 79 d'oxyde.

Puis on réalise la diffusion d'impuretés d'un premier type dans le substrat Si de la couche 50, le polysilicium (76 et 77) et servant de masque à cette diffusion. On constitue une première zone dopée 80, d'une concentration élevée dans l'exemple de réalisation d'un IGFET.

A la figure 8, on a représenté une quatrième étape du procédé selon l'invention. On réalise une oxydation contrôlée de la couche de polysilicium 76 ou 77 de la figure 7 et du silicium de la couche 50 à travers la fenêtre 70.

Comme le plot de source 88 est pris sur la zone dopée 80, les impuretés sont dirigées vers le bas par redistribution thermique. D'autre part, la croissance thermique de l'oxyde transforme la géométrie des zones extérieures de la couche de polysilicium en augmentatant la hauteur totale de l'empilement des couches à l'extérieur des plots de protection 89 et en pénétrant à cet endroit dans les couches de polysilicium 83. Enfin, les couches de nitrure 86 et 87 sont particulièrement oxydées a une vitesse réduite au dixième de celle des couches de polysilicium ce qui permet à l'homme de métier de calculer les hauteurs respectives initiales de chaque couche en fonction de la hauteur finale désirée de chaque couche.

A la figure 9, on a représenté une dernière étape du procédé de fabrication selon l'invention. On y a réalisé successivement :

- une attaque générale de l'oxyde supérieur qui a fait disparaître la couche 89 du plot de protection ; on note que les couches 84,85 et 88 d'oxydes sont du même coup diminuées,
- une attaque de la couche de nitrure 86,87, alors découverte ; comme les conditions d'attaque du nitrure et de l'oxyde sont différentes, l'oxyde n'est pas atteint et protège largement les couches de silicium 50 et 83, donc la zone dopée 80,
- une nouvelle attaque oxyde de la sous couche d'oxyde suivante qui a permis de protéger le polysilicium 83 lors de la gravure du nitrure ; comme à l'attaque précédente, les plots d'oxyde de contacts sont encore diminués,
- une attaque de polysilicium au niveau des plots de protection (ailleurs le silicium et le polysilisium sont protégés par de l'oxyde).

On obtient ainsi deux fenêtres auto-centrées 95,96 sur la zone principale dopée, dont les dimensions sont garanties par celles des plots de protection initiale. Ces deux fenêtres séparent des plots de contact 91,92 (oxyde + poly) de grille 90, (oxyde) de source et 92,94 (oxyde + poly) de grille.

A travers ces fenêtres, on réalise tout d'abord une diffusion d'impuretés du premier type (P par exemple) dans des zones 97,98 intérieures à la première zone 101 de même type. Le dopage, pour un IGFET, sera réalisé à une concentration moins élevée. Puis on réalise une diffusion d'impuretés de second type (N dans l'exemple réalisé) en zone 99,100 intérieures aux zones 97,98.

Il ne reste plus qu'à exécuter les métallisations des contacts et les opérations de finition classique.

On notera, ici, que les diffusions finales ont été exécutées à travers une couche continue d'oxyde qui culmine au plot 90 de grille de l'IG-FET. Une redistribution des impuretés est nécessaire par une opération de recuit. Dans un autre exemple de réalisation, on a réalisé une nouvelle attaque de l'oxyde supérieur de manière à dégager complétement les fenêtres 95,96 de leur oxyde. Les hauteurs des trois plots d'oxyde 90-92 sont calculées en conséquence.

Les avantages de l'invention sont nombreux. On va les illustrer dans le domaine des composants discrets, de puissance ou non. On analyse le fonctionnement d'un VD-MOS par sa résistance Rb detransfert de porteurs dans le transistor parasite qu'il présente. Cette valeur est responsable :

- des déclenchement parasites en

$$\frac{d\,V_{DS}}{dt}$$

- des déclenchements parasites en thysistor, dans le cas d'une structure BIP-MOS ; en effet cette structure qui utilise une paire de transistors bipolaire complémentaires crée un thyristor bipolaire parasite dont le courant d'amorçage varie avec Rb ; le thyristor parasite peut déclencher quand le courant circule sous la source fortement dopée $N^+$ (zone 99 par exemple) vers la zone de contact dopée P-(zone 97).

On sait repousser facilement le second type de déclenchements en diminuant la longueur de la source $N^+$ (zones 99 et 100). Mais, dans des technologies à haute intégration, ou d'autres où la longueur de source est déjà faible, il devient difficile de conserver un contrôle de ce paramètre dimensionnel.

En règle générale, on cherche à diminuer la résistance Rb. Il faut augmenter le dopage en impuretés de type P (plus généralement du premier type selon la terminologie de la description) dans la zone considérée. Celà conduit à modifier les paramètres du canal et on est conduit naturellement à étendre la zone P (dopée de premier type) à forte concentration 101 jusqu'aux bords de la couche de polysilicium c'est-à-dire sous les deux fenêtres 95 et 96. Mais il ne faut pas dépaser cette limite pour ne pas pénaliser la tension de seuil du MOS. Il faut donc garantir que la zone fortement dopée 101 sera :

- centrée relativement au plot de grille,
- limitée géométriquement par les extrêmités des fenêtres 95,96.

Or ceci est impossible à garantir en superposant plusieurs masques comme dans les procédés de l'art antérieur, où les erreurs d'alignement cumulées aboutissent à une erreur de 1 à 2 micromètres sur la fenêtre primaire 24 de la figure 2 de l'art antérieur.

Un autre avantage de l'invention appliquée aux technologies VD-MOS est de permettre de garantir avec une haute précision que le courant de retournement parasite sera constant pour une série de composants ayant suivi le même processus.

Un autre avantage de l'invention est de permettre le gain d'une étape de photomasquage comportant les opérations :

- dépôt de résine,
- d'insolation,
- de retrait de résine.

Enfin, l'invention permet de réduire les tailles de la cellule en se libérant des tolérances dues aux erreurs d'alignement. Dans une réalisation, avec des appareils de fabrication identiques, on a pu passer de cellules de 22 micromètres à des cellules de 18 micromètres, ce qui représente un gain en occupation sur silicium de 25 %.

L'invention a été décrite dans le cas d'un transistor VD-MOS. Elle s'applique à des cellules de toutes technologies où des masques de lithographie sont remplaçables par des plots de protection consommables au cours du processus de fabrication.

**Revendications**

1. Procédé de fabrication d'un composant MOS, comportant, notamment en vue de centrer des zones (80) de dopage et pour supprimer des défauts de centrage de celles-ci, les étapes suivantes :
   - former un sandwich constitué d'une première couche d'oxyde (65), d'une couche de nitrure (64), et d'une seconde couche d'oxyde (63) d'épaisseurs prédéterminées, au dessus d'un substrat (50) recouvert d'une mince couche d'oxyde (51) et d'une couche intermédiaire (52) de silicium polycristallin ;
   - graver ledit sandwich selon un motif de masque (55) de façon à laisser en place deux plots protecteurs (61, 62), l'intervalle entre les deux plots correspondant à une première zone à doper selon un premier type de conductivité et la position des plots correspondant à deux fenêtres sur des secondes zones à doper successivement selon les premier et deuxième type de conductivité ;

- enlever le silicium polycristallin dans la première zone et éliminer l'oxyde de silicium apparent ;
- réaliser un dopage d'un premier type à forte concentration dans la première zone à doper ;
- oxyder l'ensemble de telle sorte que les plots protecteurs sont beaucoup moins oxydés que le reste ;
- décaper partiellement cet oxyde puis enlever les plots ; et
- réaliser un dopage du premier puis du second type de conductivité dans les secondes zones.

2. Procédé selon la revendication 1, caractérisé en ce qu'il comporte l'ouverture d'une fenêtre (70) par un masquage (68) plus large que l'accès à la première zone à doper (80).

## Claims

1. A method of manufacturing an MOS component, comprising, particularly with a view to centering doping zones and suppressing defects of centering thereof, the following steps:
   - forming a sandwich comprising a first oxide layer (65), a nitride layer (64) and a second oxide layer (63) of predetermined thicknesses, on a substrate (50) covered with a thin oxide layer (51) and an intermediate polysilicon layer (52);
   - etching said sandwich in accordance with a mask pattern (55) while leaving two protective studs (61, 62), the interval between said studs corresponding to a first zone to be doped according to a first conductivity type and the position of said studs corresponding to two windows to be successively doped according to the first and second conductivity type;
   - etching away the polysilicon in said first zone and the apparent silicon oxide;
   - doping the first zone to be doped with a first type dopant at a high concentration;
   - oxidizing the whole so that the protective studs are much less oxidized than the rest;
   - partially etching this oxide then etching away said studs; and
   - doping successively said second zones with dopants of the first and second conductivity types.

2. The method of claim 1, characterized in that it includes the opening of a window (70) through a mask (68) wider than the access to the first zone to be doped (80).

## Patentansprüche

1. Verfahren zum Herstellen eines MOS-Bausteins, mit den folgenden Schritten, insbesondere in Hinsicht auf das Zentrieren von Dotierungsbereichen (80) und zum Unterdrücken von Fehlern bei deren Zentrierung:
   - Bilden einer Sandwich-Anordnung aus einer ersten Oxidschicht (65), einer Nitridschicht (64) und einer zweiten Oxidschicht (63) vorgegebener Dicken auf einem Substrat (50), das mit einer dünnen Oxidschicht (51) und einer Zwischenschicht (52) aus polykristallinem Silizium bedeckt ist,
   - Ätzen der Sandwich-Anordnung gemäß einem Maskenmuster (55), so daß zwei Schutzansätze (61,62) belassen werden, wobei der Zwischenraum zwischen den zwei Ansätzen einem ersten gemäß einer ersten Leitfähigkeitsart zu dotierenden Bereich entspricht und die Position der Ansätze zwei Fenstern auf zweiten, nacheinander gemäß der ersten und einer zweiten Leitfähigkeitsart zu dotierenden Bereichen entspricht,
   - Abtragen des polykristallinem Siliziums im ersten Bereich und Entfernen des auftretenden Siliziumoxids,
   - Dotieren des ersten zu dotierenden Bereichs gemäß einer ersten Dotierungsart mit hoher Konzentration,
   - Oxidieren der gesamten Anordnung, derart daß die Schutzansätze wesentlich weniger oxidiert werden als der Rest,
   - teilweises Anätzen dieses Oxids und daraufhin Abtragen der Ansätze und
   - Dotieren der zweiten Bereiche gemäß einer ersten und dann gemäß einer zweiten Leitfähigkeitsart.

2. Verfahren nach Anspruch 1, **gekennzeichnet** durch das Öffnen eines Fensters (70) durch eine Maske (68), die größer als der Zugang zum ersten zu dotierenden Bereich (80) ist.

FIG_1

FIG_2

FIG_3

FIG_4

FIG_5

FIG_6

FIG_7

# FIG_8

# FIG_9